# EUROPÄISCHE PATENTANMELDUNG

(11) **EP 2 927 723 A1**
(43) Veröffentlichungstag der Anmeldung: **07.10.2015**
(21) Anmeldenummer: 15161705.7
(22) Anmeldetag: 30.03.2015
(51) Int. Cl.: G02B 6/42, H03K 17/94, G01V 8/12

(54) **ANNÄHERUNGSSENSOREINRICHTUNG FÜR EINE BEDIENEINRICHTUNG**

(30) Priorität: 31.03.2014 DE 102014205909
(71) Anmelder: TechniSat Digital GmbH, 54550 Daun (DE)
(72) Erfinder: Bretschneider, Tilo, 01259 Dresden (DE)

(57) **Zusammenfassung**

Die Erfindung betrifft eine Annäherungssensoreinrichtung 1 für eine Bedieneinrichtung 6, die zum Erkennen des Annäherns eines Objektes an die Bedieneinrichtung 6 eingerichtet und beispielsweise in einem Fahrzeuginnenraum angeordnet ist. Die Annäherungssensoreinrichtung 1 weist eine Lichtquelle 3, einen Lichtleiter 2, einen Lichtsensor 4 und eine Steuereinheit 5 auf, wobei die Steuereinheit 5 mit der Bedieneinrichtung 6 elektrisch verbunden und die Steuereinheit 5 zum Auswerten von elektrischen Signalen des Lichtsensors 4 eingerichtet ist.

Der im Wesentlichen als ein längliches Prisma ausgebildete Lichtleiter 2 weist vier größtenteils ebene Seitenflächen, die jeweils nahezu parallel zur Längsachse des Lichtleiters 2 verlaufen und zwei größtenteils ebene Stirnflächen 14a, 14b, welche jeweils nahezu senkrecht zur Längsachse des Lichtleiters 2 verlaufen, auf. Eine der Seitenflächen ist als Lichteinkoppelfläche 10 ausgebildet und eine der Seitenflächen, welche der Lichteinkoppelfläche 10 gegenüberliegt, als Lichtauskoppelfläche 13 ausgebildet ist. Die Lichteinkoppelfläche 10 weist einen ersten äußeren Lichteinkoppelbereich 11a, welcher an der ersten der Stirnflächen 14a angeordnet ist, einen zweiten äußeren Lichteinkoppelbereich 11b, welcher an der zweiten der Stirnflächen 14b angeordnet ist, und einen inneren Lichteinkoppelbereich 12, welcher zwischen den äußeren Lichteinkoppelbereichen 11 a, 11 b angeordnet ist, auf.

## Beschreibung

Die Erfindung betrifft eine Annäherungssensoreinrichtung für eine Bedieneinrichtung, die zum Erkennen des Annäherns eines Objektes an die Bedieneinrichtung eingerichtet und beispielsweise in einem Fahrzeuginnenraum angeordnet ist.

Elektronische Geräte für den Einsatz in einem Fahrzeuginnenraum, beispielsweise Rundfunkempfangseinrichtungen, Klimaanlagen und Navigationsgeräte werden mit Bedieneinrichtungen, wie mechanischen Schaltelementen, Drehknöpfen oder berührungssensitiven Displays bedient. Die berührungssensitiven Displays, die im Sichtbereich eines Nutzers positioniert werden, stellen jeweils eine Bedienoberfläche bereit. Mithilfe der Bedienoberfläche werden Informationen ausgegeben und können Bedienfunktionen durch einen Nutzer ausgelöst werden. Das Auslösen der Bedienfunktionen kann erfolgen, indem ein Bedienfeld der Bedienoberfläche auf dem berührungssensitiven Display berührt wird, aber auch bereits, wenn sich ein Objekt, wie ein Finger des Nutzers oder ein Bedienobjekt, wie ein Stift sich dem Display annähert.

Zum Erkennen des Annäherns eines Fingers an das berührungssensitive Display wird die Annäherungssensoreinrichtung eingesetzt.

Bei herkömmlichen Annäherungssensoreinrichtungen besteht das Problem, dass nicht jede Annäherung eines Objektes erkannt wird, weil sich das annähernde Objekt in einem sogenannten toten Winkel befinden kann. Ein anderes Problem besteht darin, dass es zu Fehlerkennungen eines Objektes kommen kann, wodurch eine Bedienfunktion ungewollt ausgelöst werden kann, sodass der Nutzer vom Verkehrsgeschehen abgelenkt wird.

Die Aufgabe der vorliegenden Erfindung besteht darin, eine kostengünstige Annäherungssensoreinrichtung mit einem einfachen Aufbau bereitzustellen, die ein Annähern eines Objektes an eine Bedieneinrichtung fehlerfrei erkennt.

Diese Aufgabe wird mit einer Annäherungssensoreinrichtung gemäß Patentanspruch 1 gelöst. Ferner wird die Aufgabe mit einem Verfahren zum Erkennen des Annäherns eines Objektes an eine Bedieneinrichtung gemäß Patentanspruch 10 gelöst. Weitere Ausführungsformen der Erfindung sind in den abhängigen Ansprüchen beschrieben.

Die Annäherungssensoreinrichtung für eine Bedieneinrichtung gemäß der Erfindung weist eine Lichtquelle, einen Lichtleiter, einen Lichtsensor und eine Steuereinheit auf, wobei die Steuereinheit mit der Bedieneinrichtung elektrisch verbunden ist und die Steuereinheit zum Auswerten von elektrischen Signalen des Lichtsensors eingerichtet ist.

Der Lichtleiter ist im Wesentlichen als ein längliches Prisma ausgebildet, welches vier größtenteils ebene Seitenflächen, die jeweils nahezu parallel zur Längsachse des Prismas verlaufen, und eine der Seitenflächen als Lichteinkoppelfläche ausgebildet ist, eine der Seitenflächen, welche der Lichteinkoppelfläche gegenüberliegt, als Lichtauskoppelfläche ausgebildet ist, eine weitere der Seitenflächen als Deckfläche ausgebildet ist, und eine der Seitenflächen, welche der Deckfläche gegenüberliegt, als Grundfläche ausgebildet ist. Ferner weist der Lichtleiter zwei größtenteils ebene Stirnflächen auf, welche jeweils nahezu senkrecht zu der Längsachse des Prismas verlaufen, wobei
- die Lichteinkoppelfläche einen ersten äußeren Lichteinkoppelbereich, welcher an der ersten der Stirnflächen angeordnet ist, einen zweiten äußeren Lichteinkoppelbereich, welcher an der zweiten der Stirnflächen angeordnet ist, und einen inneren Lichteinkoppelbereich, welcher zwischen den äußeren Lichteinkoppelbereichen angeordnet ist, aufweist,
- jeder der Lichteinkoppelbereiche einen gewölbten Bereich aufweist, dessen senkrecht zur Längsachse des Lichtleiters verlaufender Querschnitt nach außen gewölbt ist,
- der innere Lichteinkoppelbereich über einen ersten nahezu ebenen Abschnitt der Lichteinkoppelfläche mit dem ersten äußeren Lichteinkoppelbereich verbunden ist und über einen zweiten nahezu ebenen Abschnitt der Lichteinkoppelfläche mit dem zweiten äußeren Lichteinkoppelbereich verbunden ist,
- der erste äußere Lichteinkoppelbereich bezüglich der Ebene des ersten Abschnitts in Richtung der Lichtauskoppelfläche geneigt ist, und der zweite äußere Lichteinkoppelbereich bezüglich der Ebene des zweiten Abschnitts in Richtung der Lichtauskoppelfläche geneigt ist.

Die nahezu ebene Deckfläche und die nahezu ebene Grundfläche verbinden die Lichteinkoppelfläche mit der Lichtauskoppelfläche.

Die Annäherungssensoreinrichtung kann Bestandteil einer Multimediaeinheit in einem Fahrzeuginnenraum sein, welche zumindest teilweise mit einem berührungssensitiven Display bedient wird. Die Multimediaeinheit kann einen Bordcomputer, eine Navigationseinheit, eine Klimaeinheit und/oder eine Radioeinheit umfassen. Die Annäherungssensoreinrichtung kann auch eine unabhängige Einheit bilden, die mit der Bedieneinrichtung der Multimediaeinheit elektrisch verbunden ist.

In beiden Fällen kann der erfindungsgemäße Lichtleiter der Annäherungssensoreinrichtung unterhalb der Bedieneinrichtung in einem Armaturenbrett derart positioniert sein, sodass die Lichtauskoppelfläche zum Nutzer hin weist und die Lichteinkoppelfläche vom Nutzer weg weist.

Die Erfindung wird anhand der Figuren näher erläutert, welche Folgendes darstellen:
- Figur 1: einen schematischen Aufbau einer Annäherungssensoreinrichtung gemäß der Erfindung
- Figur 2: einen gedachten Detektionsraum im Bereich einer Bedieneinrichtung
- Figur 3: eine perspektivische Ansicht einer Ausführungsform eines Lichtleiters gemäß der Erfindung
- Figur 4: eine perspektivische Ansicht einer weiteren Ausführungsform des Lichtleiters
- Figur 5: eine Ansicht der Lichteinkoppelfläche des Lichtleiters
- Figur 6: eine Draufsicht auf den Lichtleiter
- Figur 7: eine Ansicht einer Stirnfläche des Lichtleiters
- Figur 8: eine Ansicht einer Schnittfläche des Lichtleiters

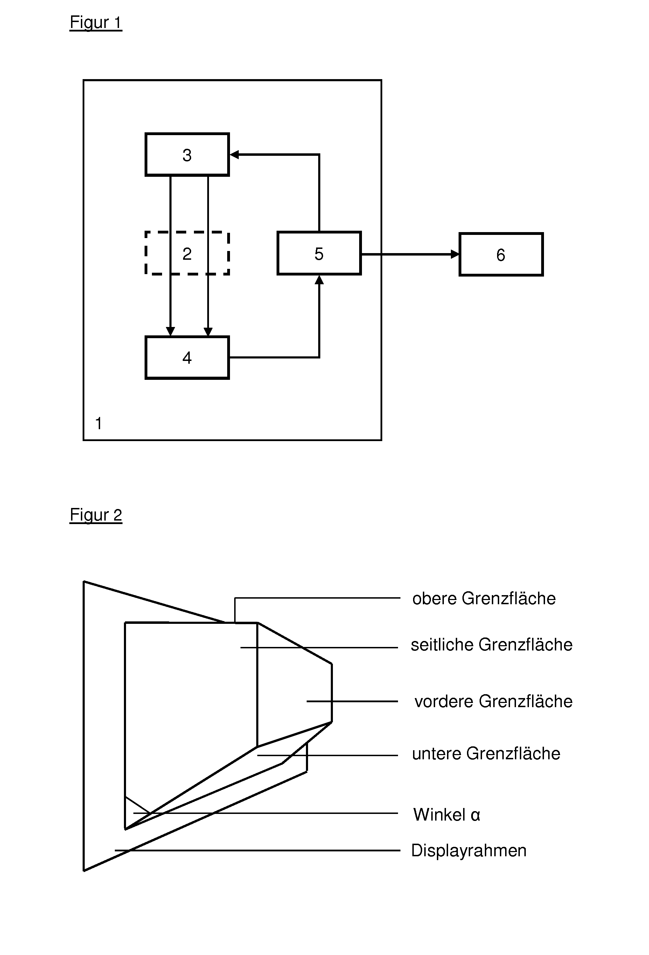

Figur 1 zeigt den schematischen Aufbau der Annäherungssensoreinrichtung 1 gemäß der Erfindung, welche einen speziell ausgebildeten Lichtleiter 2 aufweist, der aus einem transparenten Material, wie Kunststoff oder Glas hergestellt sein kann. Ein Beispiel für einen transparenten Kunststoff ist klares Polykarbonat.

Als weitere Elemente der Annäherungssensoreinrichtung 1, welche im Bereich einer Bedieneinrichtung 6 positioniert ist, sind eine Lichtquelle 3, ein Lichtsensor 4 und eine Steuereinheit 5 dargestellt. Die Annäherungssensoreinrichtung 1 kann weitere Bestandteile aufweisen, die nicht in der Figur dargestellt sind.

Die Lichtquelle 3 kann eine oder mehrere Leuchtdioden des sichtbaren Lichtbereichs, des UV-Bereichs oder des IR-Bereichs aufweisen.

In einer Ausführungsform der Erfindung weist die Lichtquelle vier Infrarot-Leuchtdioden mit einer jeweiligen Abstrahlcharakteristik in Form eines Leuchtkegels mit einem Abstrahlwinkel von ca. 50° auf.

Von der Lichtquelle 3 ausgestrahltes Licht wird in den Lichtleiter 2 eingekoppelt. Die Lichtquelle 3 kann zusätzlich eine weitere Leuchtdiode aufweisen, die in den Figuren nicht dargestellt ist und als Referenzleuchtdiode fungiert. Für diese Referenzleuchtdiode kann der Lichtleiter 2 eine in der Figur nicht dargestellte Lichteinkoppelnase aufweisen, die derart positioniert ist, dass der Lichtkegel der Leuchtdioden zum Lichtkegel der Referenzleuchtdiode um einen Winkel versetzt ist, der beispielsweise 90° beträgt. Mit der Referenzleuchtdiode können durch die Steuereinheit 5 Temperatur- und Umgebungslichteinflüsse kompensiert werden.

Die Lichtquelle 3 ist von Gehäuseteilen beispielsweise der Bedieneinrichtung 6 abgeschottet, um einen Lichtaustritt aus unerwünschten Bereichen zu vermeiden.

Der Lichtsensor 4, welcher entsprechend der verwendeten Lichtquelle 3 ausgewählt wird, kann eine Fotodiode sein. Von der Lichtquelle 3 ausgestrahltes Licht wird in den Lichtleiter 2 eingekoppelt und tritt aus der Lichtauskoppelfläche 13 aus. Wenn beispielsweise ein Finger des Nutzers, eine der Grenzflächen des Detektionsraumes erreicht, wird das von der Lichtquelle 3 abgestrahlte Licht vom Finger reflektiert, welches dann auf den Lichtsensor 4 trifft. Der Lichtsensor 4 generiert in Abhängigkeit vom empfangenen Licht elektrische Signale, die an die Steuereinheit 5 weitergeleitet werden.

Die Steuereinheit 5, die mit der Bedieneinrichtung 6 elektrisch verbunden ist, ist zum Auswerten der elektrischen Signale des Lichtsensors 4 und zum Steuern der Lichtquelle 3 eingerichtet. Die Steuereinheit 5 umfasst einen integrierten Schaltkreis mit einem digitalen Anteil, der Logikfunktionen ausführt, einen Treiber für die Lichtquelle 3 sowie eine Auswertelogik. Die Steuereinheit 5 ist dazu eingerichtet, elektrische Signale an die Bedieneinrichtung 6 weiterzuleiten, um eine Bedienfunktion auszulösen, wenn ein Annähern an die Bedieneinrichtung 6 erkannt wurde.

Mit der Bedieneinrichtung 6 kann die Multimediaeinheit in dem Fahrzeuginnenraum bedient werden. Zum Bedienen der Multimediaeinheit weist die Bedieneinrichtung 6 neben mechanischen Schaltelementen, wie Drehknöpfen ein berührungssensitives Display auf. Das berührungssensitive Display ist im Sichtbereich und Zugriffsbereich des Nutzers positioniert. Der Zugriffsbereich ist der Bereich, in dem der Nutzer die Displayoberfläche aus einer sitzenden Position heraus mit einer Hand erreichen kann.

Das berührungssensitive Display kann ein berührungssensitives Flüssigkristalldisplay sein, welches einen Rahmen zum Aufnehmen und Halten des Displays im Armaturenbrett oder in der Mittelkonsole des Fahrzeuginnenraums aufweist.

Die Bedieneinrichtung 6 weist ein berührungssensitives Display auf, das zum Anzeigen einer Bedienoberfläche mit Bedienfeldern eingerichtet ist.

Durch ein Berühren des Displays durch ein Bedienobjekt im Bereich eines angezeigten Bedienfeldes kann der Nutzer die Eingabe einer Routenoption oder das Ändern von Audioeinstellungen vornehmen. Zu den Bedienobjekten zählt beispielsweise ein Finger, die Hand eines Nutzers oder ein Stift.

Das Auslösen der Bedienfunktionen erfolgt nicht nur, indem ein Bedienfeld auf dem berührungssensitiven Display berührt wird, sondern auch bereits, wenn von der Annäherungssensoreinrichtung 1 erkannt wird, dass ein Bedienobjekt sich dem Display annähert.

Dadurch, dass eine Bedienfunktion bereits ausgelöst wird, wenn sich ein Bedienobjekt an die Bedieneinrichtung 6 annähert, wird vorteilhaft die Zeit, in der der Nutzer seine Aufmerksamkeit dem Display zuwendet und vom Verkehrsgeschehen abgelenkt ist, minimiert.

Der in **Figur 2** gezeigte Detektionsraum im Bereich einer Bedieneinrichtung 6 ist ein gedachter Raum in Form eines Prismas, der durch zwei seitliche, eine obere, eine untere, eine vordere und eine hintere Grenzfläche begrenzt wird, wobei die zwei seitlichen Grenzflächen die Stirnflächen des Prismas bilden. Die Grenzflächen des Detektionsraumes sind als diejenigen Flächen definiert, ab deren Erreichen ein Bedienobjekt im Bereich der Bedieneinrichtung 6 von der Annäherungssensoreinrichtungl frühestens erkannt werden soll.

Die Annäherungssensoreinrichtung 1 deckt zum Erkennen der Annäherung eines Objektes an das berührungssensitive Display den Detektionsraum ab, der die komplette nutzerseitige Oberfläche des Displays einbezieht und scharf abgegrenzt ist.

Die hintere Grenzfläche des prismenförmigen Detektionsraumes wird von der nutzerseitigen Oberfläche des berührungssensitiven Displays gebildet. Parallel zur hinteren Grenzfläche in Richtung des Nutzers liegt die vordere Grenzfläche. Die obere Grenzfläche verbindet die vordere und hintere Grenzfläche miteinander. Gegenüber der oberen Grenzfläche liegt die untere Grenzfläche.

Ausgehend von der hinteren Grenzfläche steigt die untere Grenzfläche in Richtung der vorderen Grenzfläche um einen Winkel α an, der beispielsweise 75° betragen kann.

Die Ausdehnung des Detektionsraumes hängt unter anderem von der Geometrie und den Abmessungen des Lichtleiters 2 sowie von der Art der verwendeten Lichtquelle 3 und deren Positionierung bezüglich des Lichtleiters 2 ab.

Durch die gezeigte Positionierung der Grenzflächen des Detektionsraumes, insbesondere der unteren Grenzfläche, wird die Anzahl der Fehlerkennungen eines Objektes im Bereich der Bedieneinrichtung 6 minimiert.

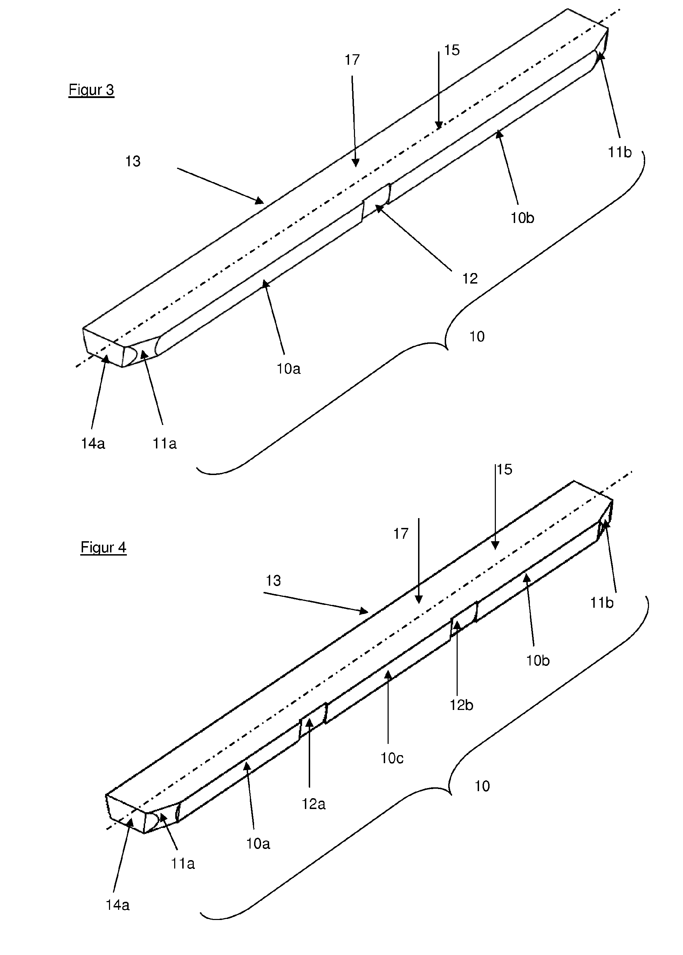

**Figur 3** zeigt eine perspektivische Ansicht einer Ausführungsform des Lichtleiters 2. Der transparente Lichtleiter 2, dessen Breite der Breite des berührungssensitiven Displays der Bedieneinrichtung 6 entsprechen kann, weist eine kompakte Form auf, die leicht und kostengünstig herzustellen ist.

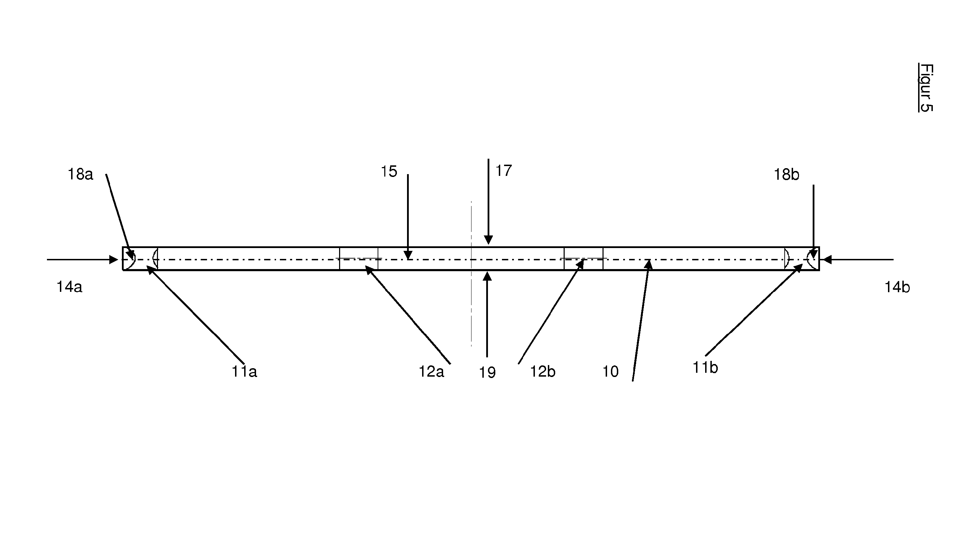

Der Lichtleiter 2, der im Wesentlichen als ein längliches Prisma ausgebildet ist, welches vier größtenteils ebene Seitenflächen aufweist, die jeweils nahezu parallel zur Längsachse 15 des Prismas verlaufen. Eine der Seitenflächen ist als Lichteinkoppelfläche 10 ausgebildet, eine zweite der Seitenflächen, welche der Lichteinkoppelfläche 10 gegenüberliegt, ist als Lichtauskoppelfläche 13 ausgebildet, eine weitere der Seitenflächen ist als Deckfläche 17 ausgebildet, und eine der Seitenflächen, welche der Deckfläche 17 gegenüberliegt, ist als Grundfläche 19 ausgebildet, wie in Figur 5 dargestellt.

Ferner weist der Lichtleiter 2 zwei größtenteils ebene Stirnflächen 14a, 14b auf, welche jeweils nahezu senkrecht zu einer Längsachse 15 des Prismas verlaufen.

Die Lichteinkoppelfläche 10 weist einen ersten äußeren Lichteinkoppelbereich 11a, welcher an der ersten der Stirnflächen 14a angeordnet ist, einen zweiten äußeren Lichteinkoppelbereich 11b, welcher an der zweiten der Stirnflächen 14b angeordnet ist, und einen inneren Lichteinkoppelbereich 12, welcher zwischen den äußeren Lichteinkoppelbereichen 11a, 11 b angeordnet ist, auf.

Jeder der Lichteinkoppelbereiche 11a, 11 b, 12 weist einen gewölbten Bereich auf, dessen senkrecht zur Längsachse 15 des Lichtleiters 2 verlaufender Querschnitt nach außen gewölbt ist. Dabei ist der innere Lichteinkoppelbereich 12 über einen ersten nahezu ebenen Abschnitt 10a der Lichteinkoppelfläche 10 mit dem ersten äußeren Lichteinkoppelbereich 11a verbunden und über einen zweiten nahezu ebenen Abschnitt 10b der Lichteinkoppelfläche 10 mit dem zweiten äußeren Lichteinkoppelbereich 11 b verbunden ist.

Die zweite Seitenfläche des Lichtleiters 2, die als Lichtauskoppelfläche 13 ausgebildet ist, weist einen ebenen durchgehenden Lichtauskoppelbereich auf, der sich über die gesamte Lichtauskoppelfläche 13 erstreckt.

Der erste äußere Lichteinkoppelbereich 11 a kann bezüglich der Ebene des ersten Abschnitts 10a in Richtung der Lichtauskoppelfläche 13 geneigt sein und der zweite äußere Lichteinkoppelbereich 11 b kann bezüglich der Ebene des zweiten Abschnitts 10b in Richtung der Lichtauskoppelfläche 13 geneigt sein.

Durch diese Neigung der äußeren Lichteinkoppelbereiche 11a, 11 b erfolgt eine Brechung der äußeren schräg aus dem Lichtleiter 2 austretenden Lichtstrahlen der Lichtquelle 3, sodass diese senkrecht zur Lichtleiteroberfläche austreten. Dadurch wird eine Minderung ungewollter Reflexionen an der äußeren Lichtleiterbegrenzung erzielt und die Erkennung von Objekten im Bereich der Bedieneinrichtung 6 gegenüber bekannten Lichtleitern verbessert.

In einer Ausführungsform des Lichtleiters 2 bildet die Ebene der Lichtauskoppelfläche 13 mit der Ebene der Lichteinkoppelfläche 10 einen spitzen Winkel aus, daraus resultiert, dass ausgehend von der hinteren Grenzfläche des Detektionsraumes die untere Grenzfläche in Richtung der vorderen Grenzfläche um einen Winkel α ansteigt.

In einer nicht dargestellten Ausführungsform der Erfindung grenzt ein innerer Lichteinkoppelbereich 12 direkt an die beiden äußeren Lichteinkoppelbereiche 11a, 11b.

Die **Figur 4** zeigt eine perspektivische Ansicht einer weiteren Ausführungsform des Lichtleiters 2, wobei der innere Lichteinkoppelbereich 12 zwei Lichtteileinkoppelbereiche 12a und 12b aufweist. Die Lichtteileinkoppelbereiche 12a und 12b sind durch einen dritten nahezu ebenen Abschnitt 10c miteinander verbunden.

Jeder der Lichtteileinkoppelbereiche 12, 12a, 12b weist einen gewölbten Bereich auf, dessen senkrecht zur Längsachse des Lichtleiters 2 verlaufender Querschnitt nach außen gewölbt ist. Die Lichteinkoppelfläche 10 kann einen oder mehrere äußere Lichteinkoppelbereiche 11a, 11 b, einen oder mehrere innere Lichteinkoppelbereiche 12, 12a, 12b aufweisen, welche jeweils durch einen ebenen Abschnitt 10a, 10b, 10c miteinander verbunden sind.

Die nahezu ebenen Abschnitte10a, 10b, 10c, mit denen die äußeren Lichteinkoppelbereiche 11a, 11 b und die inneren Lichtteileinkoppelbereiche 12, 12a 12b miteinander verbunden sind, können gleich lang sein, um eine homogene Abdeckung des Detektionsraumes zu erzielen.

Die äußeren Lichteinkoppelbereiche 11a, 11 b können unmittelbar an den Enden der Lichteinkoppelfläche 10 an den Stirnflächen 14a, 14b angeordnet sein oder beispielsweise einen Abstand von wenigen Millimetern zu den Stirnflächen 14a, 14b aufweisen.

Die Figuren 3 und 4 zeigen, dass jeder der inneren und äußeren Lichteinkoppelbereiche 12, 12a, 12b, 11a, 11 b mindestens eine Wölbung aufweist, die derart ausgebildet ist, dass ein senkrecht zur Längsachse des Lichtleiters 2 verlaufender Querschnitt nach außen gewölbt ist.

Der Lichteinkoppelbereich 12 des Lichtleiters 2 der vorliegenden Erfindung kann beliebig viele innere Lichtteileinkoppelbereiche aufweisen.

**Figur 5** zeigt eine Ansicht der Lichteinkoppelfläche 10 des Lichtleiters 2 mit der Längsachse 15, den Stirnflächen14a, 14b, den äußeren Lichteinkoppelbereichen 11a, 11b und den inneren Lichtteileinkoppelbereichen 12a, 12b. Ferner ist die Position der Deckfläche 17 und der Grundfläche 19 zur Lichteinkoppelfläche 10 dargestellt.

Die Figur 5 zeigt ferner, dass jeder der äußeren Lichteinkoppelbereiche 11 a, 11b einen Adaptionsbereich 18a, 18b aufweist, der unmittelbar an die jeweilige Stirnfläche 14a, 14b angrenzt. Die Adaptionsbereiche 18a, 18b können bezüglich der Ebene des jeweiligen Abschnitts 10a, 10b stärker als der restliche Bereich des jeweiligen Lichteinkoppelbereichs 11a, 11 b in Richtung der Lichtauskoppelfläche 13 geneigt sein.

In einer Ausführungsform der Erfindung weist einer der Adaptionsbereiche 18a, 18b einen gewölbten Bereich auf, dessen senkrecht zur Längsachse Lichtleiters verlaufender Querschnitt nach außen gewölbt ist.

In einer Ausführungsform der Erfindung weist der äußere Lichteinkoppelbereich 11a, 11 b und/oder der Adaptionsbereich 18a, 18b einen gerundeten Bereich aufweist, dessen parallel zur Deckfläche des Lichtleiters 2 verlaufender Querschnitt nach außen gerundet ist.

In einer weiteren Ausführungsform weisen die Adaptionsbereiche 18a, 18b einen ebenen Bereich auf.

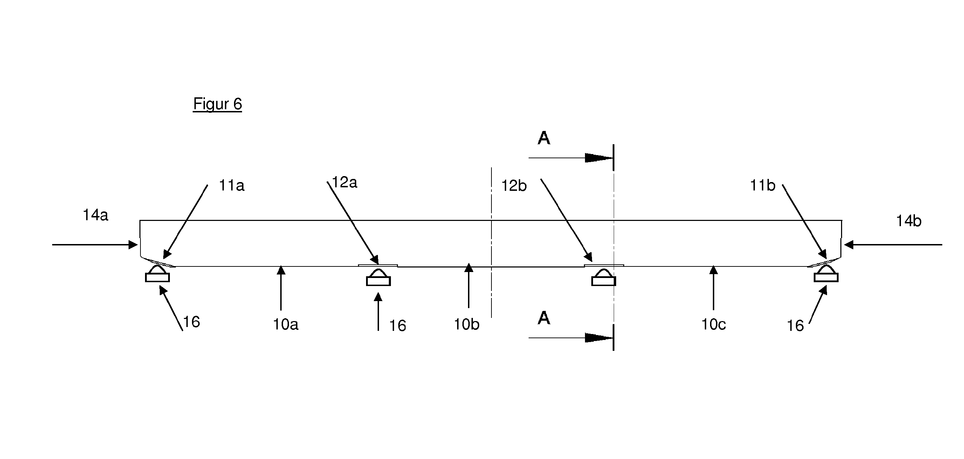

**Figur 6** zeigt eine Draufsicht auf die Deckfläche 17 des länglichen Lichtleiters 2 und den Verlauf der Schnittfläche A-A, durch einen der Teillichteinkoppelbereiche 12a, 12b. Ferner sind die beiden äußeren Lichteinkoppelbereiche 11a, 11 b, welche direkt an den beiden Stirnflächen 14a, 14b positioniert sind, und die Leuchtdioden 16 der Lichtquelle 3 dargestellt.

Die Leuchtdioden 16, die Infrarotleuchtdioden sein können, sind mit einem minimalen Abstand zu den äußeren Lichteinkoppelbereichen 11a, 11 b und den inneren Teillichteinkoppelbereichen 12a, 12b positioniert, sodass das emittierte Licht der Leuchtdioden 16 mit geringem Verlust in die Lichteinkoppelbereiche 11a, 11 b, 12a, 12b einkoppeln kann.

Durch den Abstand, der weniger als einen Millimeter betragen kann, wirkt die Wärme, die im Betrieb der Leuchtdioden 16 entsteht, nicht direkt auf den Leichtleiter 2 ein. Der Abstand kann 0,2 bis 0,3 mm betragen.

Die Figur 6 zeigt, dass der erste äußere Lichteinkoppelbereich 11 a bezüglich der Ebene des ersten Abschnitts 10a in Richtung der Lichtauskoppelfläche 13 geneigt ist und der zweite äußere Lichteinkoppelbereich 11 b bezüglich der Ebene des zweiten Abschnitts 10b in Richtung der Lichtauskoppelfläche 13 geneigt ist.

Durch diese Neigung wird der Fokus der in diesem Bereich positionierten Leuchtdiode 16 verkippt, sodass die äußeren schräg austretenden Lichtstrahlen derart gebrochen werden, dass die Lichtstrahlen senkrecht zur Lichtleiteroberfläche austreten. Das führt zu einer Reduzierung von ungewollten Reflexionen an einer äußeren Lichtleiterbegrenzung.

Es können die Adaptionsbereiche 18a, 18b bezüglich der Ebene der Abschnitt 10a, 10b in Richtung der Lichtauskoppelfläche 13 stärker geneigt sein, als die äußeren Lichteinkoppelbereiche 11a, 11b.

In einer Ausführungsform der Erfindung weisen die Stirnflächen 14a, 14b zur Längsachse des Lichtleiters 2 einen Winkel auf, der 91° beträgt.

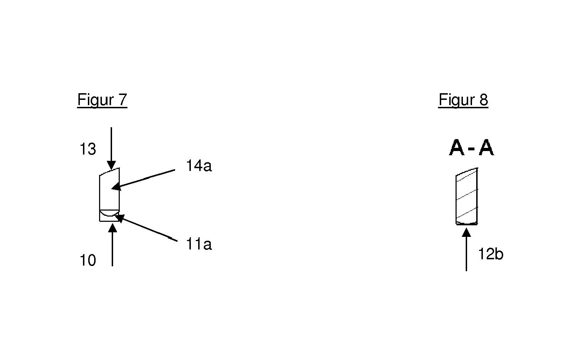

In **Figur 7** ist eine Ansicht der Stirnflächen 14a, 14b des Lichtleiters 2 und einer der äußeren Lichteinkoppelflächen 11a, 11 b dargestellt. Ferner zeigt Figur 7, dass die Ebene der Lichteinkoppelfläche 10 mit der Ebene der Lichtauskoppelfläche 13 einen spitzen Winkel ausbildet.

Durch die Lage der Lichtauskoppelfläche 13 bezüglich der Lichteinkoppelfläche 10 ist der Detektionsraum vor der Bedienvorrichtung 6 derart ausgebildet, dass ausgehend von der hinteren Grenzfläche des Detektionsraumes seine untere Grenzfläche in Richtung seiner vorderen Grenzfläche um einen Winkel α ansteigt, welcher ca. 75° betragen kann.

In einer Ausführungsform des Lichtleiters 2 weisen die Stirnflächen 14a, 14b eine Mattierung auf, um Störstrahlung aus dem Lichtleiter 2 in diesen Bereichen zu reduzieren. Ferner können die ebene Deckfläche 17 oder die ebene Grundfläche 19 mattierte Bereiche aufweisen, um den Einfluss von ungewolltem Übersprechen (Crosstalk) auf eine Referenzleuchtdiode zu verringern. **Figur 8** zeigt eine Ansicht der Schnittfläche A-A des inneren Teillichteinkoppelbereiches 12b, der einen gewölbten Bereich aufweist, dessen senkrecht zur Längsachse 15 des Lichtleiters 2 verlaufenden der Querschnitt nach außen gewölbt ist.

Die vorliegende Erfindung wird anhand einer Multimediaeinrichtung erklärt, die ein berührungssensitives Display als Bedieneinrichtung 6 aufweist und im Armaturenbrett oder der Mittelkonsole im Sichtbereich und Zugriffsbereich des Nutzers in einem Fahrzeuginnenraum installiert ist. Die Multimediaeinrichtung kann in einem Radiomodus oder Navigationsmodus betrieben werden. Für jeden dieser Modi werden von einer Steuereinheit 5 verschiedene Menüseiten generiert und am berührungssensitiven Display angezeigt. Mit den Menüseiten und Bedienfeldern können einem Nutzer zusätzliche Bedienfunktionen bereitgestellt werden.

Die Bedienfelder können im Radiomodus über oder neben eine Liste mit allen empfangbaren Sendern eingeblendet werden oder im Navigationsmodus über dem Kartenausschnitt eines aktuell befahrenen Gebietes. Im Radiomodus kann mithilfe eines der Bedienfelder die Lautstärke geregelt und/oder es können Programm- oder Toneinstellungen vorgenommen werden. Im Navigationsmodus kann eine Zieleingabe, die Zoomeinstellung einer Karte und/oder eine Routenoption ausgewählt werden.

Das Aktiveren der Multimediaeinrichtung kann mit dem Starten des Fahrzeugmotors erfolgen oder bereits, wenn sich der Fahrer dem Fahrzeug annähert. In beiden Fällen erfolgt parallel zum Aktivieren der Multimediaeinrichtung auch das Aktivieren der integrierten Annäherungssensoreinrichtung 1.

Dazu wird über die Steuereinheit 5, die Bestandteil der Multimediaeinrichtung oder der Annäherungssensoreinrichtung 1 sein kann, die Lichtquelle 3 eingeschaltet. Im vorliegenden Beispiel weist die Lichtquelle 3 vier Infrarotleuchtdioden mit einem Abstrahlwinkel von jeweils 50° auf. Der Lichtleiter 2 des vorliegenden Beispiels weist zwei innere Teillichteinkoppelbereiche 12a, 12b und zwei äußere Lichteinkoppelbereiche 11a, 11 b auf. Der Lichtleiter 2 ist mit geringem Abstand unter dem berührungssensitiven Display positioniert und wird von einem Blendenfenster geschützt.

Erreicht ein Finger des Nutzers der eingeschalteten Multimediaeinheit, die sich Radiomodus befindet, eine der Grenzflächen des Detektionsraumes, der von der Annäherungssensoreinrichtung 1 generiert wird, so wird ein elektrisches Signal von der Steuereinheit 5 ausgegeben und an das Display weitergeleitet. Von diesem werden nach Erkennen des Annäherns des Fingers automatisch Bedienfelder für den Radiomodus eingeblendet, beispielsweise im unteren Bereich der Bedienoberfläche. Über diese Bedienfelder kann der Nutzer durch Berühren des Displays im Bereich eines der Bedienfelder die Lautstärke einstellen, den Klang einstellen oder einen Radiosender aus einer angezeigten Liste auswählen, die alle empfangbaren Sender aufweist. Nachdem der Finger des Nutzers den Detektionsbereich wieder verlassen hat, werden die Bedienfelder wieder ausgeblendet.

Der Lichtleiter 2 der erfindungsgemäßen Annäherungssensoreinrichtung 1 weist wenig gegliederte Seitenflächen auf, die an den inneren und äußeren Lichteinkoppelbereichen 12, 12a, 12b, 11a, 11 b entweder einen oder zwei Bereiche aufweisen, die gewölbt sind. Somit ist der Lichtleiter 2 einfach aufgebaut und auch kostengünstig herstellbar, beispielsweise in einem Spritzgussverfahren.

Mit dem erfindungsgemäßen Lichtleiter 2 und der speziellen Anordnung der Lichtquelle 3 der Annäherungssensoreinrichtung 1 wird erreicht, dass ein Objekt, unabhängig davon aus welcher Richtung es sich der Bedieneinrichtung 6 annähert, fehlerfrei erkannt wird. Der Nutzer der Multimediaeinheit kann sich im Umfeld der Bedieneinrichtung 6, außerhalb des scharf begrenzten prismenförmigen Detektionsraumes bewegen, um beispielsweise ein mechanisches Bedienelement, welches ebenfalls im Sichtbereich des Nutzers positioniert ist, zu betätigen, ohne eine ungewollte Bedienfunktion auszulösen.

Durch das fehlerfreie Erkennen des Annäherns eines Objektes an die Bedieneinrichtung 6 durch die erfindungsgemäße Annäherungssensoreinrichtung 1 wird vermieden, dass ungewollte Bedienfunktionen durch die Bedieneinrichtung 6 gestartet werden, die einen Nutzer vom Verkehrsgeschehen ablenken.

## Patentansprüche

1. Annäherungssensoreinrichtung (1) für eine Bedieneinrichtung (6), welche eine Lichtquelle (3), einen Lichtleiter (2), einen Lichtsensor (4) und eine Steuereinheit (5) aufweist,
- wobei die Steuereinheit (5) mit der Bedieneinrichtung (6) elektrisch verbunden ist und die Steuereinheit (5) zum Auswerten von elektrischen Signalen des Lichtsensors (4) eingerichtet ist,
- wobei der Lichtleiter (2) im Wesentlichen als ein längliches Prisma ausgebildet ist, welches vier größtenteils ebene Seitenflächen, die jeweils nahezu parallel zur Längsachse des Lichtleiters (2) verlaufen, und zwei größtenteils ebene Stirnflächen (14a, 14b), welche jeweils nahezu senkrecht zur Längsachse des Lichtleiters (2) verlaufen, aufweist,
- wobei eine der Seitenflächen als Lichteinkoppelfläche (10) ausgebildet ist, eine der Seitenflächen, welche der Lichteinkoppelfläche (10) gegenüberliegt, als Lichtauskoppelfläche (13) ausgebildet ist, eine weitere der Seitenflächen als Deckfläche (17) ausgebildet ist, und eine der Seitenflächen, welche der Deckfläche (17) gegenüberliegt, als Grundfläche (19) ausgebildet ist, wobei
- die Lichteinkoppelfläche (10) einen ersten äußeren Lichteinkoppelbereich (11 a), welcher an der ersten der Stirnflächen (14a) angeordnet ist, einen zweiten äußeren Lichteinkoppelbereich (11 b), welcher an der zweiten der Stirnflächen (14b) angeordnet ist, und einen inneren Lichteinkoppelbereich (12), welcher zwischen den äußeren Lichteinkoppelbereichen (11a, 11 b) angeordnet ist, aufweist,
- jeder der Lichteinkoppelbereiche (11 a, 11 b, 12) einen gewölbten Bereich aufweist, dessen senkrecht zur Längsachse des Lichtleiters (2) verlaufender Querschnitt nach außen gewölbt ist,
- der innere Lichteinkoppelbereich (12) über einen ersten nahezu ebenen Abschnitt (10a) der Lichteinkoppelfläche (10) mit dem ersten äußeren Lichteinkoppelbereich (11a) verbunden ist und über einen zweiten nahezu ebenen Abschnitt (10b) der Lichteinkoppelfläche (10) mit dem zweiten äußeren Lichteinkoppelbereich (11 b) verbunden ist,
- der erste äußere Lichteinkoppelbereich (11a) bezüglich der Ebene des ersten Abschnitts (10a) in Richtung der Lichtauskoppelfläche (13) geneigt ist und der zweite äußere Lichteinkoppelbereich (11b) bezüglich der Ebene des zweiten Abschnitts (10b) in Richtung der Lichtauskoppelfläche (13) geneigt ist.

2. Annäherungssensoreinrichtung (1) nach Anspruch 1, wobei jeder der äußeren Lichteinkoppelbereiche (11a, 11 b) einen Adaptionsbereich (18a, 18b) aufweist, der unmittelbar an die jeweilige Stirnfläche (14a, 14b) angrenzt und bezüglich der Ebene des jeweiligen Abschnitts (10a, 10b) stärker als der restliche Bereich des jeweiligen Lichteinkoppelbereichs (11 a, 11 b) in Richtung der Lichtauskoppelfläche (13) geneigt ist.

3. Annäherungssensoreinrichtung (1) nach Anspruch 2, wobei einer der Adaptionsbereiche (18a, 18b) einen gewölbten Bereich aufweist, dessen senkrecht zur Längsachse des Lichtleiters (2) verlaufender Querschnitt nach außen gewölbt ist.

4. Annäherungssensoreinrichtung (1) nach Anspruch 2, wobei einer der Adaptionsbereiche (18a, 18b) einen ebenen Bereich aufweist.

5. Annäherungssensoreinrichtung (1) nach Anspruch 2, wobei der äußere Lichteinkoppelbereich (11a, 11 b) und/oder der Adaptionsbereich (18a, 18b) einen gerundeten Bereich aufweist, dessen parallel zur Deckfläche des Lichtleiters (2) verlaufender Querschnitt nach außen gerundet ist.

6. Annäherungssensoreinrichtung (1) nach einem der vorhergehenden Ansprüche, wobei der innere Lichteinkoppelbereich (12) zwei Lichtteileinkoppelbereiche (12a, 12b) aufweist, die durch einen dritten nahezu ebenen Abschnitt (10c) miteinander verbunden sind, wobei jeder der Lichtteileinkoppelbereiche (12a, 12b, 12c) einen gewölbten Bereich aufweist, dessen senkrecht zur Längsachse des Lichtleiters (2) verlaufender Querschnitt nach außen gewölbt ist.

7. Annäherungssensoreinrichtung (1) nach einem der vorhergehenden Ansprüche, wobei der innere Lichteinkoppelbereich (12) beliebig viele Lichtteileinkoppelbereiche aufweist.

8. Annäherungssensoreinrichtung (1) nach einem der vorhergehenden Ansprüche, wobei die Ebene der Lichteinkoppelfläche (10) mit der Ebene der Lichtauskoppelfläche (13) einen spitzen Winkel ausbildet.

9. Annäherungssensoreinrichtung (1) nach einem der vorhergehenden Ansprüche, wobei die Lichtquelle (3) Infrarot-Leuchtdioden aufweist, die jeweils einem anderen der Lichteinkoppelbereiche (11 a, 11 b, 12, 12a, 12b) zugeordnet sind.

10. Verfahren, bei dem eine Annäherungssensoreinrichtung (1) gemäß einem der vorhergehenden Ansprüche zum Erkennen des Annäherns eines Objektes an eine Bedieneinrichtung (6) verwendet wird.
